Europäisches Patentamt

European Patent Office

Office européen des brevets

(11) Publication number: **0 363 940**
**A2**

# (12) EUROPEAN PATENT APPLICATION

(21) Application number: **89118915.1**

(22) Date of filing: **11.10.89**

(51) Int. Cl.5: **C04B 35/00 , H01L 39/12**

(30) Priority: **13.10.88 JP 258602/88**

(43) Date of publication of application:
**18.04.90 Bulletin 90/16**

(84) Designated Contracting States:
**DE FR GB**

(71) Applicant: **NEC CORPORATION**
**33-1, Shiba 5-chome**
**Minato-ku Tokyo(JP)**

(72) Inventor: **Shimakawa, Yuichi, c/o NEC**
**Corporation**
**33-1, Shiba 5-chome**
**Minato-ku Tokyo(JP)**
Inventor: **Kubo, Yoshimi, c/o NEC Corporation**
**33-1, Shiba 5-chome**
**Minato-ku Tokyo(JP)**
Inventor: **Manako, Takashi, c/o NEC**
**Corporation**
**33-1, Shiba 5-chome**
**Minato-ku Tokyo(JP)**
Inventor: **Tabuchi, Junji, c/o NEC Corporation**
**33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) **An oxide superconductor composition and a process for the production thereof.**

(57) An oxide superconductor composition comprising thallium (Tl), barium (Ba) and copper (Cu) in a form of an oxide; and atomic ratio of these elements being x:2:y wherein $1.7 \leq x \leq 2.0$ and $1.3 \leq y \leq 4.0$ is provided. This composition has a high superconducting transition temperature Tc and a high critical current density Jc.

EP 0 363 940 A2

## An oxide superconductor composition and a process for the production thereof

## BACKGROUND OF THE INVENTION

### Field of the invention

The present invention relates to an oxide superconducting material for use in various superconductivity application apparatus and superconducting devices.

### Description of the prior art

Up to the present, metal or alloy superconducting materials, intermetallic compound superconducting materials, etc. have already been put into practical use as superconducting materials. The superconducting materials are used for production of coils for superconducting magnets, electronics devices such as a Josephson device, etc. and are expected to realize applications particularly to a Superconducting Quantum Interference Device (=SQUID) and a precision measurement technique, utilizing the merits of high sensitivity, high precision and low noise properties of a Josephson junction, and also to an electronic computor, taking advantage of high speed responsibility and low electric power consumption properties of the Josephson junction.

It is desired that a critical temperature Tc at which the material changes its property to superconductive is as high as possible. Since an oxide superconductor of La-Ba-Cu-O system having a Tc around 30K was found, there are successively found oxide superconductors of Ba-Y-Cu-O system having a Tc around 90K, Bi-Sr-Ca-Cu-O system having a Tc around 110K, Tl-Ba-Ca-Cu-O system having a Tc around 120K, etc. These findings of the materials having Tc far exceeding a liquid nitrogen temperature are further enhancing expectations for use as practical materials.

For applying a superconducting material to an electronics device, it is preferred that its Tc is as high as possible. It is also important that the critical current density Jc is as large as possible, from the viewpoint of wiring materials. A Tl-Ba-Cu-O system composition, when the atomic ratio of Tl:Ba:Cu is x:2:y wherein $1.7 \leq x \leq 2.0$ and $1.0 \leq y \leq 1.2$, does not show superconductivity at all or show superconductivity only at a very low temperature below 10K, after sintering.

## SUMMARY OF THE INVENTION

An object of the present invention is therefore to present a superconductor which has a Tc higher than that of the prior art superconductor and at the same time has a high Jc and a process for the production thereof.

The present inventors have found through intensive and extensive researches that an oxide superconductor composition comprising thallium (Tl), barium (Ba) and copper (Cu) in a form of an oxide; an atomic ratio of these elements being x:2:y wherein wherein $1.7 \leq x \leq 2.0$ and $1.3 \leq y$ $4.0$ gives after pressure molding and sintering a sintered body having a high Tc and also that the properties of the sintered body can be further improved by wrapping a pressure molded body with a gold foil at sintering.

In effect, the present inventors have confirmed by experiments that a composition of $Tl_2 Ba_2 Cu_3 O_8$ - (x:2:y = 2:2:3), after pressure molding and sintering at 890° C for three hours, has a Tc of 90K and a Jc of 800 A/cm² at the liquid nitrogen temperature 77K.

On the other hand, it has also been confirmed that a composition of $Tl_2 Ba_2 Cu O_6$ (x:2:y = 2:2:1), after pressure molding and sintering at 890° C for one hour, does not show superconductivity at a temperature not lower than the liquid helium temperature of 4.2 K; and that the same composition, after pressure molding, sintering at 890° C for three hours and slow cooling, has a Tc only of 10K.

## DESCRIPTION OF THE PREFERRED EMBODIMENTS

2

The present invention will be explained below further in detail with respect to its some embodiments shown as working examples.

As for starting materials, thallium oxide ($Tl_2O_3$), barium oxide (BaO) and cupric oxide (CuO), respectively of 99% or more purity were used. These materials were taken up and weighed to show each of the composition ratios as shown in the following table 1, well mixed in a mortar and then pressed into a pressed body in a size of 5mm x 10mm x lmm. This pressed body was sintered at 840 - 900°C for 1 - 10 hours in an oxygen atmosphere. Separately, the pressed body was wrapped with a gold foil and sintered at the same conditions.

Then measurements were made on the samples obtained from the composition ratios and under various conditions as to their resistivities, critical current densities, and superconductivity volume fractions in order to evaluate their superconductivity properties.

The resistivity was measured by using a dc four probe method. The electrical contacts were made by using gold electrodes sputtered on the sample surface and the copper lead wires plated with tin.

The critical current density also was measured by the dc four probe method. The current value at which $0.1\mu V$ or more voltage was generated between the voltage leads at the liquid nitrogen temperature of 77K was employed as Jc.

The superconductivity volume fraction was obtained by an ac magnetic susceptibility measurement, which was carried out by determining any change of inductance L of a coil wherein a sample was placed, and calculating on the basis of $\Delta$L at 4.2K of lead of the same volume and the same shape as equal to 100.

The resitivity measurement was made within a temperature range of from a room temperature to a temperature showing zero resistivity and the magnetic susceptibility measurement was made within a temperature range of from a room temperature to 4.2K.

In the table 1, the critical temperature Tc at which the resistivity becomes zero, the critical current density Jc at 77K and the superconductivity volume fraction as measured on the samples are shown along with the composition ratios and the sintering conditions.

Table 1

| Sample No. | Tl:Ba:Cu ratio | Sintering condition | Tc | Jc | Volume fraction |
|---|---|---|---|---|---|
| | (x:2:y) | | (K) | (A/cm$^2$) | (%) |
| 1 * | 1.5:2.0:1.0 | 880°C; 3hrs | - | - | - |
| 2 | 1.7:2.0:1.3 | 880°C; 3hrs | 80 | 600 | 80 |
| 3 | 2.0:2.0:2.0 | 890°C; 3hrs | 85 | 600 | 85 |
| 4 | 2.0:2.0:3.0 | 890°C; 3hrs | 90 | 800 | 80 |
| 5 | 2.0:2.0:4.0 | 890°C; 3hrs | 85 | 680 | 75 |
| 6 | 2.0:2.0:6.0 | 880°C; 3hrs | 80 | 200 | 30 |

* ... did not show superconductivity at the liquid helium temperature 4.2K

As shown in the above, the compositions according to the present invention give a high Tc, Jc and volume fraction.

It was also found that in case the samples were wrapped with gold foil and sintered, the property values were improved for about 10 percents or more.

It is to be noted however that if x was made less than 1.7 or y less than 1.3, no superconductivity property was shown or only very low Tc was obtained and so such composition ratio is not suitable for the purpose of the present invention, that if x was made larger than 2.0 and y larger than 4.0, the volume fraction and therefore Jc was reduced, owing to too much impurity phases, and so such composition ratio is not suitable for practical use.

Further, the sintering conditions should desirably be within ranges of 840 - 900°C and 1 - 10 hours in an oxygen atmosphere in order to obtain excellent sintered bodies.

Thus the present invention provides a very useful superconducting material having a high superconducting transition temperature Tc and a process for the production thereof.

**Claims**

1. An oxide superconductor composition comprising thallium (Tl), barium (Ba) and copper (Cu) in a form of an oxide; an atomic ratio of these elements being x:2:y wherein $1.7 \leq x \leq 2.0$ and $1.3 \leq y \leq 4.0$.

2. A process for the production of an oxide superconductor composition comprising thallium (Tl), barium (Ba) and copper (Cu) in a form of an oxide; an atomic ratio of these elements being x:2:y wherin $1.7 \leq x \leq 2.0$ and $1.3 \leq y \leq 4.0$, in which process, powders of thallium oxide ($Tl_2O_3$), barium oxide (BaO) and cupric oxide (CuO) are mixed together in a ratio of giving the above atomic ratio, pressure molded and subjected to a heat treatment.

3. The pocess according to claim 2, wherein said powders as mixed and pressure molded are wrapped with a gold foil and then subjected to said heat treatment.

4. The process according to claim 2, wherein as said heat treatment, sintering is made at a temperature in a range of 840 - 900°C.

5. A superconducting composition essentially consisting of thallium barium copper oxide wherein atomic ratio of thallium:barium:copper is expressed by x:2:y, where $1.7 \leq x \leq 2.0$ and $1.3 \leq y \leq 4.0$.